# EUROPEAN PATENT SPECIFICATION

(11) **EP 2 096 752 B1**
(45) Date of publication and mention of the grant of the patent: **27.07.2011**
(21) Application number: 08003732.8
(22) Date of filing: 28.02.2008
(51) Int. Cl.: H03F 3/217

(54) **Switched mode amplifier**
Getakteter Verstärker
Amplificateur de mode commuté

(43) Date of publication of application: 02.09.2009
(73) Proprietor: Harman Becker Automotive Systems GmbH, 76307 Karlsbad (DE)
(72) Inventor: Jurzitza, Dieter, Dr., 76131 Karlsruhe (DE)
(74) Representative: Schmuckermaier, Bernhard

(56) References cited:
- US-A- 5 610 553

## Description

### FIELD OF TECHNOLOGY

This invention relates to a switched mode power amplifier, and in particular to a low distortion audio power amplifier.

### BACKGROUND

For example, US 5,610,553 discloses a broadband switching amplifier that utilizes an output stage capable of variable impedance transformation in addition to conventional controlled pulsewidth coupling to accurately produce output power without regard for normal power supply or load impedance constraints. In an embodiment, an inductive reactance is charged and discharged with gated switches in accordance with pulsewidth-modulated signals representative of an output signal.

A conventional switched mode audio amplifier comprises, e.g., an audio amplifier and a power supply, the audio amplifier being provided with a delta-sigma modulator for delta-sigma modulating an audio signal. An output pulse signal from the delta-sigma modulator is supplied to a power switching element in the amplifier, and then output via an output filter in the amplifier. The power supply is connected to the power switching element in the amplifier, wherein the power supply receives a clock signal, performs pulse width modulation in synchronization with this clock signal, supplies this pulse width modulated signal to a power switching element in the power supply, and supplies required power to the power switching element in the amplifier via an output filter in the power supply.

A signal such as an audio signal or the like is input to the delta-sigma modulator, and a sampling clock is input to this delta-sigma modulator at the same time. The input signal is delta-sigma modulated by the delta-sigma modulator, and the output pulse signal thereof is input to the power switching element in the amplifier. In addition, a different clock signal from the sampling clock signal is input to the power supply. Pulse width modulation is performed in synchronization with this clock signaland the pulse width modulated output pulse signal is input to the power switching element in the power supply. The output of the power switching element in the power supply is output through an output filter in the power supply, and supplies power to the power switching element in the amplifier.

However, since the power supply and the power amplifier are independent from each other in this arrangement, there is a problem that switching noise from the power supply easily affects the output of the power amplifier. In addition, a large output filter in the power supply must be installed at the output of the power supply so that switching noise from the power supply does not affect the power amplifier. However, a conventional output filter in the power supply is typically constructed such that a smoothing circuit and a noise filter are connected, and the installation of a noise filter in this case makes miniaturization difficult. Moreover, if design of the output filter in the power supply is attempted excluding a noise filter, it is necessary to enlarge a capacitor and a choke coil in the smoothing circuit. Whichever construction is used, since the output filter in the power supply is comparatively large, there is a problem that it is difficult to miniaturize the switching amplifier.

To overcome these problems, the switched power supply itself, controlled by a respective input signal, may be used also as the switched power amplifier. Such arrangements do not produce satisfactory sound quality. In particular, huge non-linear distortions are produced if energy is fed back, e.g. by an inductive load such as a loudspeaker.

It is an object of the invention to provide a practical and efficient way of amplifying an audio signal with low distortion under all circumstances and conditions.

### SUMMARY

A switched mode amplifier comprising: a switched amplifier unit that sources or sinks a negative or positive current to or from a load; said load and said current defining a voltage over said load; a controller unit receiving an input signal and a feedback signal and generating control signals for the switched amplifier unit therefrom; a feed back unit connected to the controller unit and the load for generating the feedback signal for the switched amplifier unit from the voltage over the load; wherein said switched amplifier unit being supplied by a supply voltage source and comprising: an inductance connected between a first and second node; said first node being connectable to a third node via a first controllable switch, to a fourth node via a second controllable switch, and to fifth node via a third controllable switch and first diode unit; said second node being connectable to the fourth node via a fourth controllable switch and to the fifth node via a fifth controllable switch and second diode; said first and second node are connectable via a sixth controllable switch and a third diode; wherein the switches are connected to and controlled by the controller unit and wherein said supply voltage source is connected between the third node and the fourth node and said load is connected between the fifth node and the fourth node.

### BRIEF DESCRIPTION OF THE DRAWINGS

The invention can be better understood with reference to the following drawings and description. The components in the figures are not necessarily to scale, instead emphasis being placed upon illustrating the principles of the invention. Moreover, in the figures, like reference numerals designate corresponding parts. In the drawings:
FIG. 1 is a schematic block diagram of a novel audio amplifier system ;
FIG. 2 is a simplified schematic circuit diagram of a power amplifier unit in a novel audio amplifier system ;
FIG. 3 is a table showing operating modes of the circuit of FIG. 2;
FIGS. 4-15 are simplified schematic circuit diagrams of the power amplifier unit of FIG. 2 in different operating modes and switching states;
FIG. 16 shows a graph of an output of a novel power amplifier unit ; and
FIG. 17 is an expanded view of a portion of the graph of FIG. 16.

### DETAILED DESCRIPTION

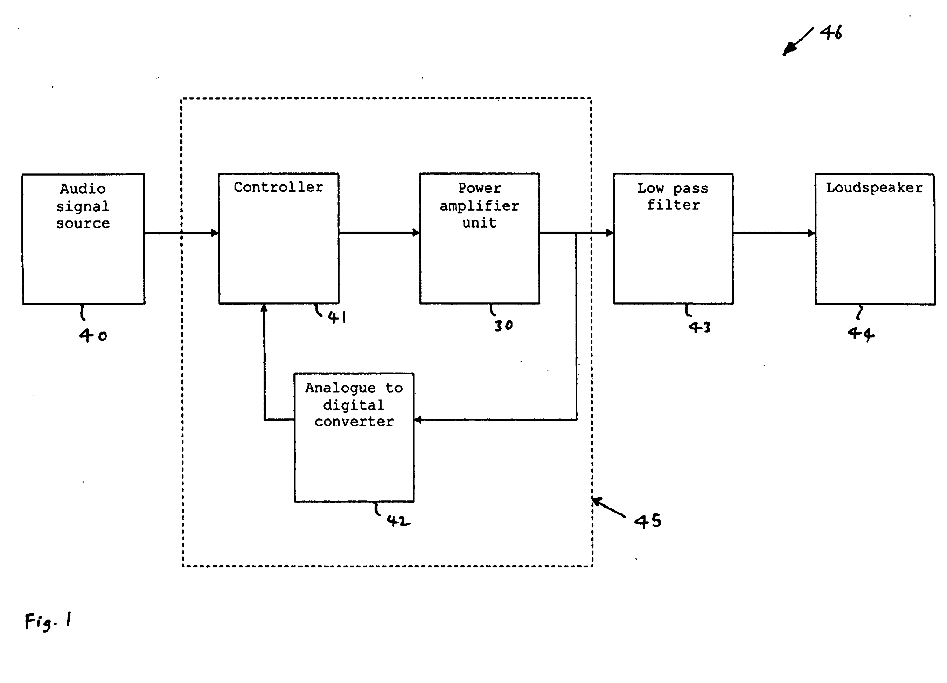

FIG. 1 is a schematic block diagram of an audio amplifier arrangement 46 which comprises an audio signal source 40, an amplifier unit 45, a low pass filter (LPF) 43 and a loudspeaker 44. The amplifier unit 45, in turn, comprises a controller 41, a power amplifier 30 and an Analog-to-Digital (AD) converter 42.

The input of the amplifier unit 45 receives a digital audio signal from the audio signal source 40. The amplifier unit 45 amplifies the audio signal and transmits the amplified signal to the filter 43. The filter 43 filters the amplified signal and sends the filtered signal to the loudspeaker 44. The audio signal source 40, for example a CD player, mp3 player, radio tuner, etc., provides an audio signal to the amplifier unit 45. This signal typically may have frequency components predominantly in the audible range of about 20 Hz (Hertz) to 22 kHz (kilo Hertz). The amplifier unit 45 amplifies the signal and supplies the amplified signal to filter 43 which removes high frequency components from the amplified signal. High frequency is defined as a frequency above the maximum audible frequency of about 22 kHz. The filtered signal is then supplied to the loudspeaker 44 which produces sound therefrom. The filter 43 is connected upstream to loudspeaker 44.

In the amplifier unit 45, the controller 41 receives a digital audio signal from the signal source 40 and a digital signal from the AD converter 42. The controller 41 sends a control signal to the amplifier unit 30. The amplifier unit 30 outputs an amplified signal to the filter 43. The amplified signal from the amplifier unit 30 is also sent to the AD converter 42.

The controller 41 delivers an essentially distortion free signal to filter 43. The controller 41 receives signals from the audio signal source 40 and the AD converter 42. Based at least on these signals, the controller 41 determines the desired output level of the power amplifier unit 30. Then, the controller 41 sets the output of the amplifier unit 30 to the desired level. The power amplifier unit 30 is able to provide a positive or negative output voltage. It is also able to source or sink current. The amplifier unit 30 uses switching power supply techniques to achieve a high efficiency.

The AD converter 42 samples the amplified signal from the amplifier unit 30. The amplified signal is sampled upstream of the low pass filter 43. The AD converter 42 reads the analog voltage value of the sampled signal and transmits the digital voltage value of the sampled signal to the controller 41. The AD converter 42 may have high input impedance, which does not alter the sampled signal. The AD converter 42 samples the amplified signal at regular time intervals. The signal is, e.g., sampled at frequencies of 44 kHz or higher which is the conventional sampling rate of CD audio. The maximum frequency of audible signal is about 22 kHz. The Nyquist sampling theorem suggests a minimum sampling rate of at least twice this frequency.

The amplified signal is sampled close to filter 43 in order to sense any distortion in the signal input into filter 43. The controller 41 controls the power amplifier unit 30 to compensate for distortions. The filter 43 removes unwanted high frequency components in the amplified signal and is located upstream of the loudspeaker 44 to reduce distortions introduced between the filter 43 and the loudspeaker 44.

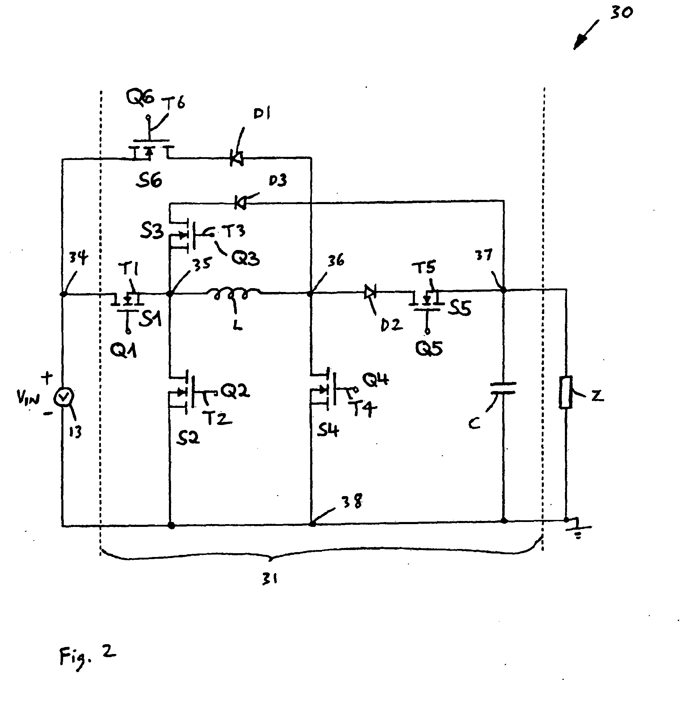

FIG. 2 is a circuit diagram of an exemplary power amplifier unit 30. The amplifier unit 30 is coupled to a load Z and comprises a DC voltage source 13 and a converter circuit 31. The converter circuit 31 comprises switches S1 to S6, diodes D1 to D3, an inductor L, a capacitor C, and nodes 34 to 38. A first end of switch S1 is coupled to one, e.g. the positive, terminal of the DC voltage source 13 thereby forming node 34. The second end of switch S1 is coupled to a first end of switch S2 thereby forming node 35. A second end of the switch S2 is coupled to the other, accordingly negative terminal of the voltage source 13 thereby forming node 38. A first end of switch S3 is coupled to node 35 and its second end is coupled to the cathode of diode D3. A first end of switch S4 is coupled to node 38 and its second end is coupled to the anode of the diode D1 thereby forming node 36. A first end of switch S5 is coupled to the cathode of diode D2. A second end of the switch S5 is coupled to the anode of the diode D3 thereby forming node 37. Finally, a first end of the switch S6 is coupled to the positive terminal of voltage source 13 whereas its second end is coupled to the cathode of diode D1. The controller 41 of FIG. 1 controls the switches S1 to S6 by means of control signals Q1-Q6.

The inductor L is connected between node 35 and node 36. The anodes of diodes D1 and D2 are coupled to the node 36 whereas the anode of diode D3 is coupled to node 37. The cathodes of the diodes D1, D2 and D3 are coupled to the switches S6, S5 and S3, respectively. This provides electrical isolation of the diodes D1, D2 and D3 when the switches S6, S5 and S3 are in an open position. The capacitor C is connected between nodes 37 and 38 and load Z is connected between nodes 37 and 38. Node 38 is connected to electrical ground. The load Z may have resistive, capacitive, and inductive components. The basic energy storage elements of the converter circuit 31 are inductor L and capacitor C.

The switches S1 to S6 may be of a semiconductor type such as, but not limited to metal-oxide-semiconductor-field-effect transistors (MOSFET) or bipolar transistors. In the present example, n-channel metal-oxide-semiconductor field-effect (NMOSFET) transistors T1-T6 are used as switches S1-S6. The transistors T1 to T6 are of the enhancement type. The substrate and the source of each of the transistors T1 to T6 may be connected together to deplete any stray electrons in the substrate.

As the transistors T1 through T6 are of the enhancement type, a high resistance exists between the source and the drain of each transistor. An n-channel is formed between the source and the drain of the transistor T1 to T6 when a positive potential difference relative to its source is applied to the gate. This reduces the resistance between its source and its drain. When a positive potential difference relative to its source is applied to its drain, electrons are caused to flow from its source to its drain. Thus electrical current flows from the drain to its source. Accordingly, the drain of the transistor T1 is coupled to the positive terminal of the voltage source 13.

The substrate of the transistor T1 is connected to its source. The source of the transistor T1 is coupled to the drain of the transistor T2 thereby forming node 35. Further, the substrate of the transistor T2 is connected to its source. The source of the transistor T2 is coupled to the negative terminal of the voltage source 13 thereby forming the node 38. The source of the transistor T3 is coupled to node 35 and its drain is coupled to the cathode of diode D3. The substrate of transistor T3 is connected to its source. The source of transistor T4 is coupled to node 38. The substrate of transistor T4 is connected to its source. In addition, its drain is coupled to the anode of the diode D2 thereby forming node 36.

The drain of the transistor T5 is coupled to the cathode of the diode D2. The substrate of the transistor T5 is connected to its source, which in turn is coupled to the anode of the diode D3 thereby forming node 37. The source of the transistor T6 is coupled to the positive terminal of voltage source 13 whereas the drain of the transistor T6 is coupled to the cathode of diode D1. The substrate of transistor T6 is connected to its source. Finally, the gates of transistors T1 to T6 are coupled to the controller 41 of FIG. 1.

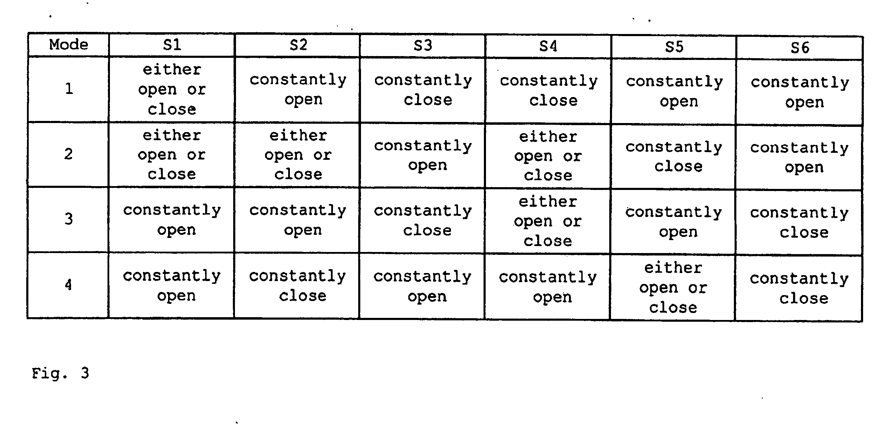

FIG. 3 is a table of the operating modes of converter circuit 31. The converter circuit 31 has four operating modes. The positions of switches S1 to S6 determine the operating modes, which establish whether the circuit 31 transfers a positive or negative voltage to load Z and whether the circuit 31 sources or sinks current to load Z.

In mode 1, the switches S2, S5 and S6 are constantly in an open position and the switches S3 and S4 are constantly in a closed position. In this mode, the circuit 31 transfers a negative voltage from the voltage source 13 to the load Z.

If circuit 31 operates in mode 2, the switches S3 and S6 are constantly in an open position and the switch S5 is constantly in a closed position. In this mode, the circuit 31 transfers a positive voltage from the DC voltage source 13 to the load Z.

In case the circuit 31 operates in mode 3, the switches S1, S2 and S5 are constantly in an open position and the switches S3 and S6 are constantly in a closed position. In this mode, the circuit 31 sinks a current from the load Z that generates a positive voltage.

In mode 4, the switches S1, S3, and S4 are constantly in an open position and the switches S2 and S6 are constantly in a closed position. In this mode, the circuit 31 sinks current from a load Z that generates a negative voltage.

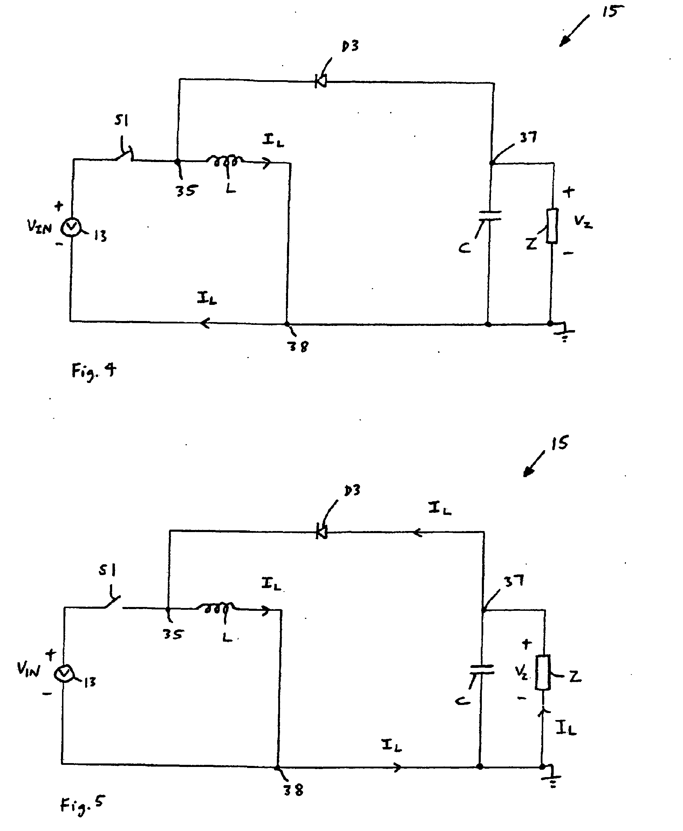

FIGS. 4, 5 and 6 show simplified circuit diagrams of the circuit of Fig. 2 for the case that the converter circuit 31 is in operating mode 1. With reference to Figs. 2 and 3, the switches S2, S5 and S6 are constantly in an open position if in mode 1. The switches S3 and S4 are constantly in a closed position. The switch S1 is toggled continuously between the open and a closed position by the controller 41.

All inactive circuit elements during mode 1 are omitted in FIGS. 4, 5 and 6. The switches S3 and s4 are replaced by short circuits in FIGS. 4, 5 and 6. As outlined above, the converter circuit 31, in mode 1, transfers a negative voltage of the DC voltage source 13 to the load Z. The circuit 31 operates in "buck-boost" converter type manner.

FIG. 4 shows switch S1 in a closed position. This allows the DC voltage V_{IN} of voltage source 13 to be applied to inductor L and the series circuit of diode D3 and load Z. The voltage V_{IN} energizes the inductor L and induces a current I_{L} to flow through inductor L. The voltage V_{IN} does not induce a flow of current through the series circuit of diode D3 and load Z since diode D3 is blocking the flow of current into the direction from the cathode of the diode D3 to its anode.

When the switch S1 opens, as shown in FIG. 5, the energy in inductor L keeps the inductor current I_{L} flowing. This current I_{L} flows into the load Z and charges the capacitor C. The current I_{L} flows from the node 38 to the node 37. Hence, the voltage V_{Z} generated on the node 37 and the inductor L, with reference to electrical ground, is negative. The voltage V_{Z} increases in magnitude as energy from the inductor L is transferred to the capacitor C and the load Z. The magnitude of voltage V_{Z} is smaller than the magnitude of the voltage V_{IN}.

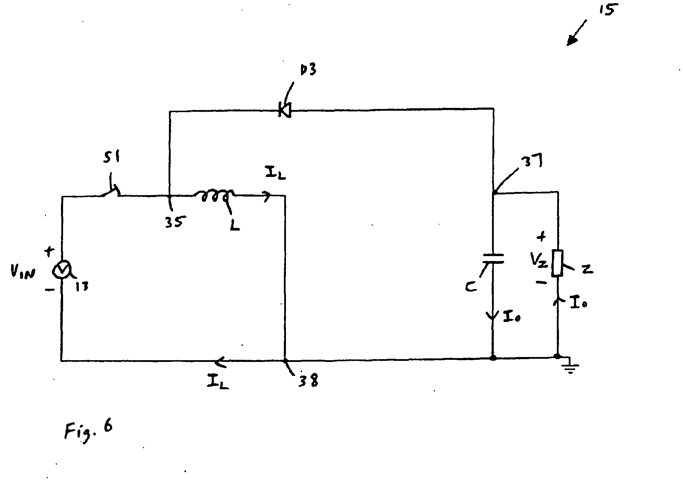

In the example of FIG. 6, the switch S1 closes. Then, the current I_{L} from the inductor L stops flowing into the load Z. However, current I_{O} from the charged capacitor C flows into the load Z and the voltage V_{Z} decreases as the energy in the capacitor C discharges. Thus, the closing and the opening of switch S1 transfers a negative voltage V_{Z} to the load Z. The voltage V_{Z} rises and falls as the inductor L and the capacitor C are charged and discharged.

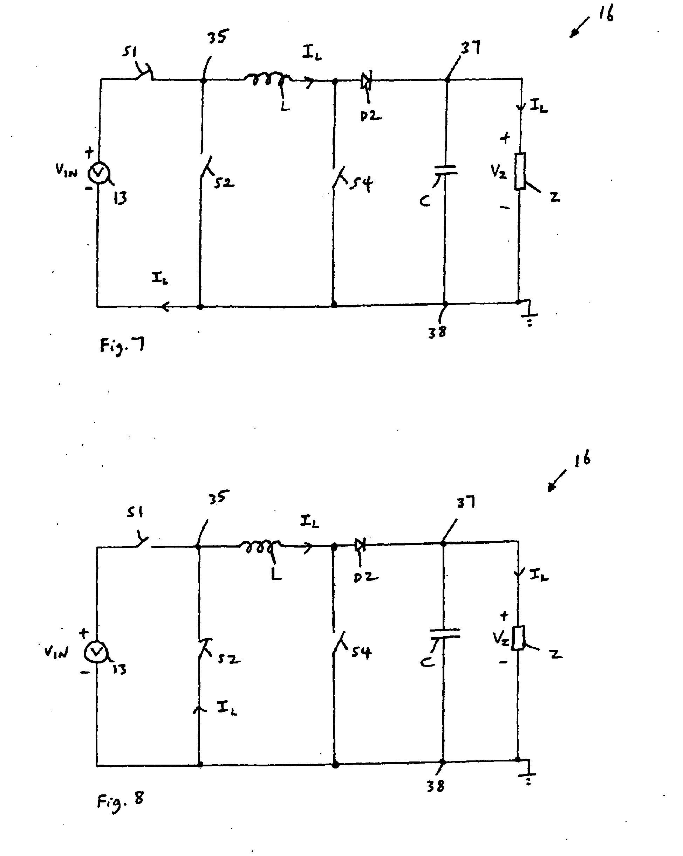

FIGS. 7, 8, 9, 10 and 11 shows different states of the circuit diagram shown in FIG. 2 in operating mode 2 according to the invention. In mode 2, with reference to FIGS. 2 and 3, the switches S3 and S6 are constantly in an open position. The switch S5 is constantly in a closed position. The inactive circuit elements in mode 2 are omitted in the FIG. 7, 8, 9, 10 and 11. A short circuit replaces the switch S5, in the FIG. 7, 8, 9, 10 and 11. In mode 2, the converter circuit 31 converts a voltage V_{IN} of the DC voltage source 13 to a positive voltage V_{Z}, which is applied to the load Z. Mode 2 has two states of operation. In state 1, the magnitude of voltage V_{IN} is greater than the voltage V_{Z}. In state 2, the magnitude of voltage V_{IN} may be less than the voltage V_{Z}.

The FIGS. 7 and 8 show the circuit 31 in mode 2, state 1. The switch S4 is constantly in an open position. The switches S1 and S2 are toggled continually between an open and a closed position by a controller, which is not shown in FIGS. 7 and 8. The controller opens the switch S1 when the switch S2 is in the closed position. The controller closes the switch S1 when the switch S2 is in the open position. The circuit 31 operates in a "buck" converter manner.

FIG. 7 shows switch S1 in a closed position and switch S2 in an open position. This enables the voltage V_{IN} of DC voltage source 13 to be applied across the series circuit of the inductor L, the diode D2 and the load Z. This energies the inductor L and causes a current I_{L} to flow through the inductor L and into the load Z. The current I_{L} flows from node 37 to node 38. As the current I_{L} starts to flow, the voltage V_{Z} across the load Z starts to increase. Hence, the voltage V_{Z} of node 37 and of the inductor L, with reference to electrical ground, is positive. The magnitude of the voltage V_{IN} is greater than the magnitude of the voltage V_{Z}.

As shown in FIG. 8, the switch S1 is in an open position and switch S2 is in a closed position. The energy in the inductor L keeps the current I_{L} in the inductor L flowing. This current I_{L} flows into the load Z. This flow depletes the energy in the inductor L thereby reducing the magnitude of the current I_{L} and of the voltage V_{Z}. The switches S1 and S2 are toggled continually between an open and a closed position and transfer a positive voltage V_{Z} to the load Z. The voltage V_{Z} rises and falls as the energy in the inductor L charges and discharges with the opening and closing of the switches S1 and S2.

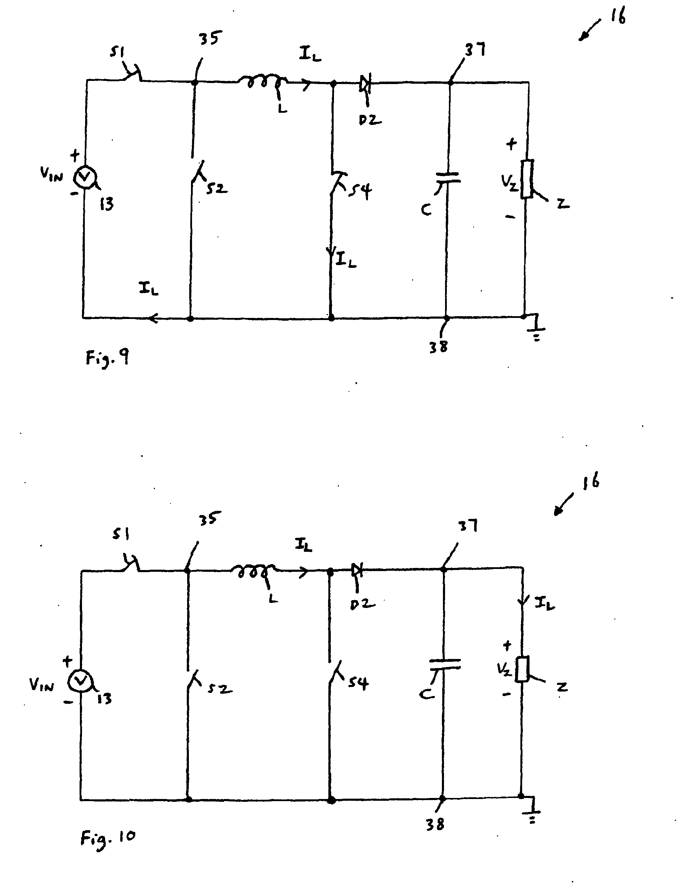

In mode 2 and state 2, the switch S1 is constantly in a closed position and the switch S2 is constantly in an open position, as shown in FIGS. 9, 10 and 11. Switch S4 is toggled continually between an open and a closed position by a controller, which is not shown. The circuit 31 operates in a "boost" converter type manner.

FIG. 9 shows the switch S4 in a closed position. This enables the voltage V_{IN} of the DC voltage source 13 to be applied across the inductor L. This energies the inductor L and induces a current I_{L} to flow through it.

Switch S4 is in an open position, as shown in FIG. 10. The current I_{L} continues to flow because of the energised inductor L and the inductor L acts like a voltage source. The potential difference across the inductor L and the DC voltage source 13 is applied across the diode D2 and the load Z. The voltage V_{Z} across the load Z rises as current starts to flow into the load Z. The voltage V_{Z} can rise to a level greater than the voltage V_{IN} due to the additional energy source of the inductor L in series with the voltage source 13. Furthermore, the capacitor C is also charged. The energy in the inductor L depletes as current I_{L} flows through the inductor L.

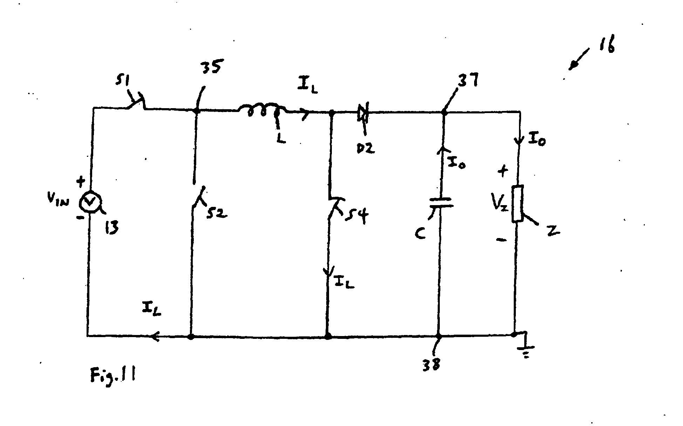

As shown in the FIG. 11 the switch S4 is in a closed position. The DC voltage source 13 energises the inductor L. A current I_{O} flows from the charged capacitor C into the load Z. The voltage V_{Z} falls as the energy in the capacitor C is discharged. Switch S4 is toggled continually between an open and a closed position. This transfers a positive voltage V_{Z} to the load Z. The magnitude of the voltage V_{Z} may be greater than the magnitude of the voltage V_{IN}. The voltage V_{Z} rises and falls as the energy in the inductor L charges and discharges with the opening and closing of the switch S4.

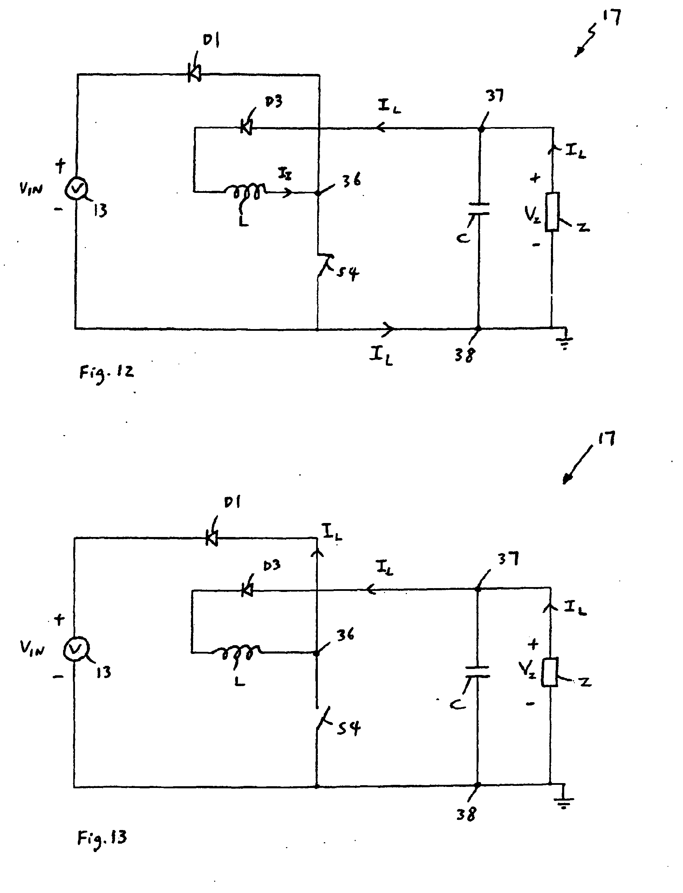

FIGS. 12 and 13 show the converter circuit 31 of FIG. 2 in operating mode 3. With reference to FIG. 2 and 3, the switches S1, S2 and S5 are constantly in an open position in mode 3. The switches S3 and S6 are constantly in a closed position. Switch S4 is toggled continually between an open and a closed position by the controller 41. The inactive circuit elements are omitted in FIGS. 12 and 13. Short circuits replace switches S3 and S6 in FIGS 12 and 13. In operating mode 3, the converter circuit 31 absorbs energy from the load Z which has a positive voltage. The circuit 31 operates in "buck" converter manner where it draws energy from the load Z.

FIG. 12 shows switch S4 in a closed position. The voltage V_{Z} across load Z is applied to the series circuit of diode D3 and inductor L. This induces a current I_{L} to flow through the inductor L from node 37 to node 36. This energises the inductor L and depletes the energy in the load Z.

As shown in FIG. 13, the switch S4 is in an open position. The current I_{L} continues to flow due to the energized inductor L. The inductor L acts like a voltage source. The voltage across the load Z and the inductor L is applied to the series circuit of the voltage source 13 and the diodes D1 and D3. Current I_{L} depletes the energy in the inductor L. Hence, the operating mode 3 discharges the energy in the load Z that has a positive voltage.

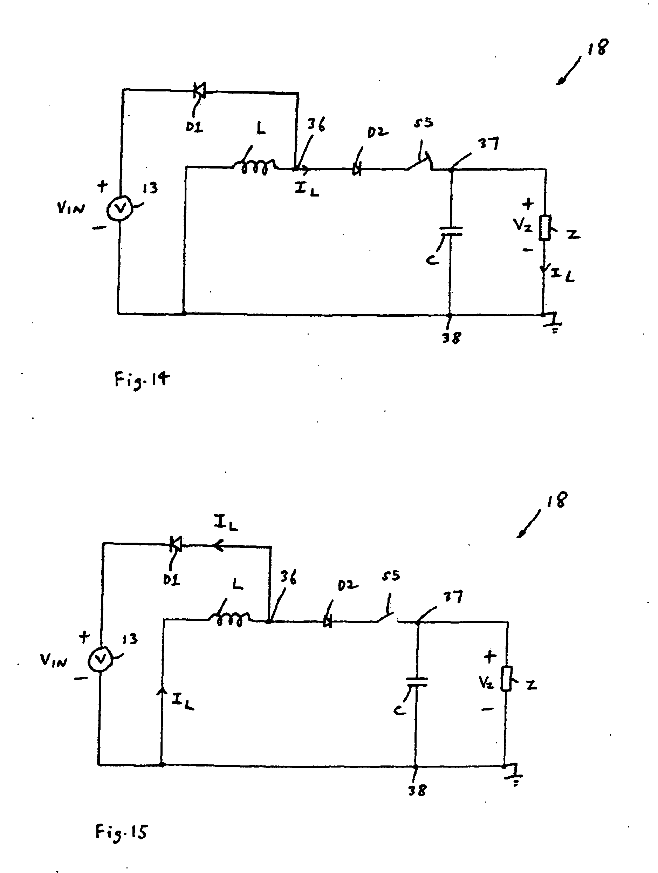

FIGS. 14 and 15 show the converter circuit 31 of FIG. 2 in operating mode 4. In mode 4 the switches S1, S3, and S4 are constantly in an open position. The switches S2 and S6 are constantly in a closed position. The switch 5 is toggled continually between an open and a closed position by controller 41. The inactive circuit elements are omitted in FIGS. 14 and 15. Short circuits replace the switches S2 and S6 in FIGS. 14 and 15. In operating mode 4, the converter circuit 31 absorbs energy from the load Z, which has a negative voltage. The circuit 31 operates in a "buck-boost" converter type circuit where it reduces the energy stored in load Z.

The switch 5 is in a closed position, as shown in the FIG. 14. The voltage V_{Z} across the load Z is applied across the series circuit of the diode D2 and the inductor L. The load Z has a negative voltage. This induces a current I_{L} to flow in the inductor L from the node 38 to the node 36. This energises the inductor L and depletes the energy in the load Z. The switch 5 is in an open position, as shown in FIG. 15. The current I_{L} flows into diode D1 and voltage source 13 such that it reduces the energy in the inductor L and accordingly the voltage across the load Z.

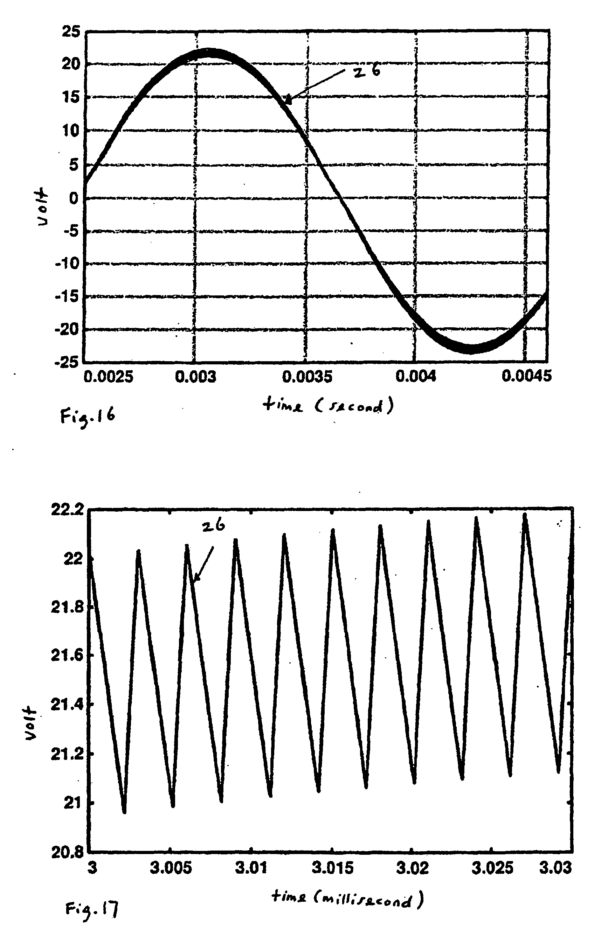

FIG. 16 shows a line graph 26 of the output voltage of the converter circuit 31 of FIG. 2 whereas the line graph 26 has a sinusoidal waveform. The graph 26 starts at 2.5 ms (milliseconds) time point with a value of about 3 volts. The graph 26 rises to about 23 volts at the 3.1 ms time point. It then falls to about negative 24 volts at the 4.3 ms time point before rising reaching about negative 15 volts at the 4.6 ms time point. The line graph 26 appears as a bold line with a maximum thickness of about 1 volt at the around the 3.1 ms and the 4.3 ms time points. The thickness of the graph 26 shows the range of variation of the output of the converter circuit 31. The graph 26 comprises a saw-tooth shaped line, which appears as a bold line in the FIG. 16. Due to its saw-tooth shape, graph 26 fluctuates at high frequencies.

FIG. 17 shows an expanded view of a portion of the graph 26 of FIG. 16 wherein graph 26 has a saw-tooth waveform of about 300 kilohertz. The graph 26 starts at 3.00 ms time point and ends at the 3.03 ms time point. The readings of the graph 26 vary between about 21 and 22 volts. The graph 26 has a slight upward incline and a peak of about 22.00 volt at the 3.000 ms time point and a peak of about 22.18 volts at the 3.027 ms time point. The frequency of the graph 26 corresponds with the toggling frequency of the switches of the circuit 31 of FIG. 2. The output voltage of the converter circuit 31 has a triangle waveform instead of a rectangle form. The distortion level introduced by the triangle waveform is at high frequencies. The level of distortion is reduced here according to the 1/f² rule and not the 1/f rule. Due to this, the disturbance level is very low.

Although various examples to realize the invention have been disclosed, it will be apparent to those skilled in the art that various changes and modifications can be made which will achieve some of the advantages of the invention without departing from the scope of the invention as defined by the appended claims.

## Claims

1. A switched mode amplifier (45) comprising:
a switched amplifier unit (30) that sources or sinks a negative or positive current to or from a load; said load and said current defining a voltage over said load;
a controller unit (41) receiving an input signal and a feedback signal and generating control signals for the switched amplifier unit therefrom;
a feed back unit (42) connected to the controller unit and the load for generating the feedback signal for the switched amplifier unit from the voltage over the load;
wherein said switched amplifier unit being supplied by a supply voltage source (13) and comprising:
an inductance (2) connected between a first (35) and second (36) node;
said first node being connectable to a third node (34) via a first controllable switch (51), to a fourth node (gnd) via a second controllable switch (52), and to fifth node (37) via a third controllable switch (53) and first diode unit (D3);
said second node being connectable to the fourth node via a fourth controllable switch (54) and to the fifth node via a fifth controllable switch (55) and second diode (D2);
said first and second nodes are connectable via a sixth controllable switch (56) and a third diode (D1);
wherein the switches are connected to and controlled by the controller unit and wherein said supply voltage source is connected between the third node and the fourth node and said load is connected between the fifth node and the fourth node.

2. The amplifier of claim 1 wherein the switches in the amplifier unit are controlled by the controller unit that depending on the input signal the amplifier unit is operated as non-inverting buck converter, non-inverting boost converter, inverting buck converter, or inverting boost converter.

3. The amplifier of claim 1 or 2 further comprising a capacitor connected between the fifth node and the fourth node.

4. The amplifier of claim 1, 2 or 3 further comprising a filter unit connected upstream of the load.

5. The amplifier of claim 4 wherein the filter is a low pass filter.

6. The amplifier of one of claims 1-5 wherein the feedback unit comprises an analog-to-digital converter.

7. The amplifier of one of claims 1-6 wherein the controllable switches are semiconductor devices.

8. The amplifier of claim 7 wherein the controllable switches MOSFETs.

9. The amplifier of claim 8 wherein the controllable switches MOSFETs of the enhancement type.

10. The amplifier of one of claims 1-6 wherein the controller unit performs digital signal processing.

## Patentansprüche

1. Schaltverstärker (45), umfassend:
eine Schaltverstärkerbaugruppe (30), welche als Quelle einen negativen oder einen positiven Strom an eine Last abgibt oder als Senke von einer Last aufnimmt; wobei die Last und der Strom eine Spannung über die Last definieren;
eine Controller-Baugruppe (41), welche ein Eingangs-Signal und ein Feedback-Signal empfängt und Steuer-Signale für die Schaltverstärkerbaugruppe daraus generiert;
eine Feedback-Baugruppe (42), welche mit der Controller-Baugruppe und der Last verbunden ist zur Erzeugung des Feedback-Signals für die Schaltverstärkerbaugruppe aus der Spannung über der Last;
wobei die Schaltverstärkerbaugruppe durch eine Versorgungsspannungsquelle (13) versorgt wird und aufweist:
eine Induktivität (L), welche zwischen einen ersten (35) und einen zweiten (36) Knoten geschaltet ist;
wobei der erste Knoten via eines ersten steuerbaren Schalters (S1) mit einem dritten Knoten (34), via eines zweiten steuerbaren Schalters (S2) mit einem vierten Knoten (gnd) und via eines dritten steuerbaren Schalters (S3) und eines ersten Diodenelements (D3) mit einem fünften Knoten (37) elektrisch verbindbar ist;
wobei der zweite Knoten mit dem vierten Knoten via eines vierten steuerbaren Schalters (S4) und mit dem fünften Knoten via eines fünften steuerbaren Schalters (S5) und einer zweiten Diode (D2) elektrisch verbindbar ist;
wobei die ersten und zweiten Knoten via eines sechsten steuerbaren Schalters (S6) und einer dritten Diode (D1) elektrisch verbindbar sind;
wobei die Schalter mit der Controller-Baugruppe verbunden sind und durch diese gesteuert werden und wobei die Versorgungsspannungsquelle zwischen den dritten Knoten und den vierten Knoten geschaltet ist und wobei die Last zwischen den fünften Knoten und den vierten Knoten geschaltet ist.

2. Verstärker nach Anspruch 1, wobei die Schalter in der Verstärkerbaugruppe durch die Controller-Baugruppe gesteuert werden, so dass die Verstärkerbaugruppe in Abhängigkeit des Eingangssignals als nicht-invertierender Tiefsetzsteller, als nicht-invertierender Hochsetzsteller, als invertierender Tiefsetzsteller oder als invertierender Hochsetzsteller betrieben wird.

3. Verstärker nach Anspruch 1 oder 2, ferner aufweisend einen Kondensator, welcher zwischen den fünften Knoten und den vierten Knoten geschaltet ist.

4. Verstärker nach Anspruch 1, 2 oder 3, ferner aufweisend eine Filterbaugruppe welche stromaufwärts der Last geschaltet ist.

5. Verstärker nach Anspruch 4, wobei das Filter ein Tiefpassfilter ist.

6. Verstärker nach einem der Ansprüche 1 bis 5, wobei die Feedback-Baugruppe einen Analog-Digital-Wandler aufweist.

7. Verstärker nach einem der Ansprüche 1 bis 6, wobei die steuerbaren Schalter Halbleiterbauelemente sind.

8. Verstärker nach Anspruch 7, wobei die steuerbaren Schalter MOSFETs sind.

9. Verstärker nach Anspruch 8, wobei die steuerbaren Schalter MOSFETs vom Anreicherungstyp sind.

10. Verstärker nach einem der Ansprüche 1 bis 6, wobei die Controller-Baugruppe digitale Signalverarbeitung durchführt.

## Revendications

1. Amplificateur en mode commuté (45) comprenant :
une unité d'amplificateur commutée (30) qui procure ou absorbe un courant positif ou négatif à ou à partir d'une charge ; ladite charge et ledit courant définissant une tension sur ladite charge ;
une unité de commande (41) recevant un signal d'entrée et un signal de réaction et générant des signaux de commande pour l'unité d'amplificateur commutée à partir de ceux-ci ;
une unité de réaction (42) connectée à l'unité de commande et à la charge permettant de générer le signal de réaction pour l'unité d'amplificateur commutée à partir de la tension sur la charge ;
ladite unité d'amplificateur commutée étant alimentée par une source de tension d'alimentation (13) et comprenant :
une bobine d'inductance (L) connectée entre un premier (35) et un deuxième noeud (36) ;
ledit premier noeud pouvant être connecté à un troisième noeud (34) au moyen d'un premier commutateur pouvant être commandé (S1), à un quatrième noeud (gnd) au moyen d'un deuxième commutateur pouvant être commandé (S2), et à un cinquième noeud (37) au moyen d'un troisième commutateur pouvant être commandé (S3) et d'une première unité de diode (D3) ;
ledit deuxième noeud pouvant être connecté au quatrième noeud au moyen d'un quatrième commutateur pouvant être commandé (S4) et au cinquième noeud au moyen d'un cinquième commutateur pouvant être commandé (S5) et d'une deuxième diode (D2) ;
lesdits premier et deuxième noeuds peuvent être connectés au moyen d'un sixième commutateur pouvant être commandé (S6) et d'une troisième diode (D1) ;
les commutateurs étant connectés à et commandés par l'unité de commande, ladite source de tension d'alimentation étant connectée entre le troisième noeud et le quatrième noeud et ladite charge étant connectée entre le cinquième noeud et le quatrième noeud.

2. L'amplificateur de la revendication 1, dans lequel les commutateurs dans l'unité d'amplificateur sont commandés par l'unité de commande au moyen de laquelle, en fonction du signal d'entrée, l'unité d'amplificateur est commandée comme un convertisseur abaisseur de tension non inverseur, un convertisseur élévateur de tension non inverseur, un convertisseur abaisseur de tension inverseur ou un convertisseur élévateur de tension inverseur.

3. L'amplificateur d'une des revendications 1 ou 2 comprenant en outre un condensateur connecté entre le cinquième noeud et le quatrième noeud.

4. L'amplificateur d'une des revendications 1, 2 ou 3 comprenant en outre une unité de filtre connectée en amont de la charge.

5. L'amplificateur de la revendication 4, dans lequel le filtre est un filtre passe-bas.

6. L'amplificateur de l'une des revendications 1 à 5, dans lequel l'unité de réaction comprend un convertisseur analogique-numérique.

7. L'amplificateur de l'une des revendications 1 à 6, dans lequel les commutateurs pouvant être commandés sont des dispositifs semiconducteurs.

8. L'amplificateur de la revendication 7, dans lequel les commutateurs pouvant être commandés sont des MOSFET.

9. L'amplificateur de la revendication 8, dans lequel les commutateurs pouvant être commandés sont des MOSFET de type à enrichissement.

10. L'amplificateur de l'une des revendications 1 à 6, dans lequel l'unité de commande effectue un traitement de signaux numériques.
